# EUROPÄISCHE PATENTSCHRIFT

(11) **EP 4 226 248 B1**
(45) Veröffentlichungstag und Bekanntmachung des Hinweises auf die Patenterteilung: **18.02.2026**
(21) Anmeldenummer: 21806944.1
(22) Anmeldetag: 11.10.2021
(51) Int. Cl.: G06F 11/36, B60W 60/00

(54) **VERFAHREN UND EIN SYSTEM ZUM TESTEN EINES FAHRERASSISTENZSYSTEMS FÜR EIN FAHRZEUG**
METHOD AND A SYSTEM FOR TESTING A DRIVER ASSISTANCE SYSTEM FOR A VEHICLE
DISPOSITIF ET SYSTÈME POUR TESTER UN SYSTÈME D'AIDE À LA CONDUITE POUR UN VÉHICULE

(30) Priorität: 12.10.2020 AT 508772020
(43) Veröffentlichungstag der Anmeldung: 16.08.2023
(73) Patentinhaber: AVL List GmbH, 8020 Graz (AT)
(72) Erfinder: NICA, Mihai, 8045 Graz (AT); FELBINGER, Hermann, 8045 Weinitzen (AT); TAO, Jianbo, 8054 Graz (AT); KLÜCK, Florian, 8020 Graz (AT); ZIMMERMANN, Martin, 8020 Graz (AT); KLAMPFL, Lorenz, 8010 Graz (AT)
(74) Vertreter: Hahner, Ralph
(86) Internationale Anmeldenummer: PCT/AT2021/060370
(87) Internationale Veröffentlichungsnummer: WO 2022/077042

(56) Entgegenhaltungen:
- FLORIAN HAUER ET AL: "Szenario-Optimierung fur die Absicherung von automatisierten und autonomen Fahrsystemen", ARXIV.ORG, CORNELL UNIVERSITY LIBRARY, 201 OLIN LIBRARY CORNELL UNIVERSITY ITHACA, NY 14853, 17 January 2019 (2019-01-17), XP081003553
- DUAN JIANLI ET AL: "Test Scenario Generation and Optimization Technology for Intelligent Driving Systems", IEEE INTELLIGENT TRANSPORTATION SYSTEMS MAGAZINE, IEEE, USA, vol. 14, no. 1, 6 February 2020 (2020-02-06), pages 115 - 127, XP011897379, ISSN: 1939-1390, [retrieved on 20220112], DOI: 10.1109/MITS.2019.2926269

## Beschreibung

Die Erfindung betrifft ein computerimplementiertes Verfahren und ein System zum Testen eines Fahrerassistenzsystems für ein Fahrzeug, wobei ein Szenario, in welchem sich das Fahrzeug befindet, simuliert wird und das Fahrerassistenzsystem in einem Umfeld des Fahrzeugs auf der Grundlage des simulierten Szenarios betrieben wird und wobei ein Fahrverhalten des Fahrerassistenzsystems in dem Umfeld des Fahrzeugs beobachtet wird.

Die Verbreitung von Fahrerassistenzsystemen (Advanced Driver Assistance Systems - ADAS), welche in einer Weiterentwicklung autonomes Fahren (Autonomous Driving - AD) ermöglichen, nehmen sowohl im Bereich der Personenkraftwagen als auch bei Nutzfahrzeugen ständig zu. Fahrerassistenzsysteme leisten einen wichtigen Beitrag zur Erhöhung der aktiven Verkehrssicherheit und dienen zur Steigerung des Fahrkomforts.

Neben den insbesondere der Fahrsicherheit dienenden Systemen wie ABS (Anti-Blockier-System) und ESP (Elektronisches Stabilitätsprogramm) werden im Bereich der Personenkraftwagen und der Nutzfahrzeuge einer Vielzahl von Fahrerassistenzsystemen angeboten.

Fahrerassistenzsysteme, welche bereits zur Erhöhung der aktiven Verkehrssicherheit eingesetzt werden, sind ein Parkassistent, ein adaptiver Abstandsregeltempomat, der auch als Adaptive Cruise Control (ACC) bekannt ist, welcher eine vom Fahrer gewählte Wunschgeschwindigkeit adaptiv auf einen Abstand zu einem vorausfahrenden Fahrzeug einregelt. Ein weiteres Beispiel für solche Fahrerassistenzsysteme sind ACC-Stop-&-Go-Systeme, welche zusätzlich zum ACC die automatische Weiterfahrt des Fahrzeugs im Stau oder bei stehenden Fahrzeugen bewirkt, Spurhalte- oder Lane-Assist-Systeme, die das Fahrzeug automatisch auf der Fahrzeugspur halten, und Pre-Crash-Systeme, die im Fall der Möglichkeit einer Kollision beispielsweise eine Bremsung vorbereiten oder einleiten, um die kinetische Energie aus dem Fahrzeug zu nehmen, sowie gegebenenfalls weitere Maßnahmen einleiten, falls eine Kollision unvermeidlich ist.

Diese Fahrerassistenzsysteme erhöhen sowohl die Sicherheit im Verkehr, indem sie den Fahrer in kritischen Situationen warnen, bis zur Einleitung eines selbstständigen Eingriffs zur Unfallvermeidung oder Unfallverminderung, beispielsweise indem eine Notbremsfunktion aktiviert wird. Zusätzlich wird der Fahrkomfort durch Funktionen wie automatisches Einparken, automatische Spurhaltung und automatische Abstandskontrolle erhöht.

Der Sicherheits- und Komfortgewinn eines Fahrerassistenzsystems wird von den Fahrzeuginsassen nur dann positiv wahrgenommen, wenn die Unterstützung durch das Fahrerassistenzsystem sicher, verlässlich und in - soweit möglich - komfortabler Weise erfolgt.

Darüber hinaus muss jedes Fahrerassistenzsystem, je nach Funktion, im Verkehr auftretende Szenarien mit maximaler Sicherheit für das eigene Fahrzeug und auch ohne Gefährdung anderer Fahrzeuge bzw. anderer Verkehrsteilnehmer bewerkstelligen.

Der jeweilige Automatisierungsgrad von Fahrzeugen wird dabei in sogenannte Automatisierungslevel 1 bis 5 unterteilt (vgl. beispielsweise Norm SAE J3016). Die vorliegende Erfindung betrifft insbesondere Fahrzeuge mit Fahrerassistenzsystemen des Automatisierungslevels 3 bis 5, welches im Allgemeinen als autonomes Fahren betrachtet wird.

Die Herausforderungen zum Testen solcher Systeme sind vielfältig. Insbesondere muss ein Ausgleich zwischen dem Testaufwand und der Testabdeckung gefunden werden. Dabei ist die Hauptaufgabe beim Testen von ADAS/AD-Funktionen, zu demonstrieren, dass die Funktion des Fahrerassistenzsystems in allen vorstellbaren Situationen gewährleistet ist, insbesondere auch in kritischen Fahrsituationen. Solche kritischen Fahrsituationen weisen eine gewisse Gefährlichkeit auf, da keine oder eine falsche Reaktion des jeweiligen Fahrerassistenzsystems zu einem Unfall führen kann.

Das Testen von Fahrerassistenzsystemen erfordert daher eine Berücksichtigung einer großen Anzahl von Fahrsituationen, welche sich in verschiedenen Szenarien ergeben können. Der Variationsraum von möglichen Szenarien wird dabei im Allgemeinen durch viele Dimensionen aufgespannt (z. B. verschiedene Straßeneigenschaften, ein Verhalten von anderen Verkehrsteilnehmern, Wetterbedingungen, etc.). Aus diesem nahezu unendlichen und multidimensionalen Parameterraum ist es zum Testen der Fahrerassistenzsysteme besonders relevant, solche Parameterkonstellationen für kritische Szenarien zu extrahieren, welche zu ungewöhnlichen oder gefährlichen Fahrsituationen führen können.

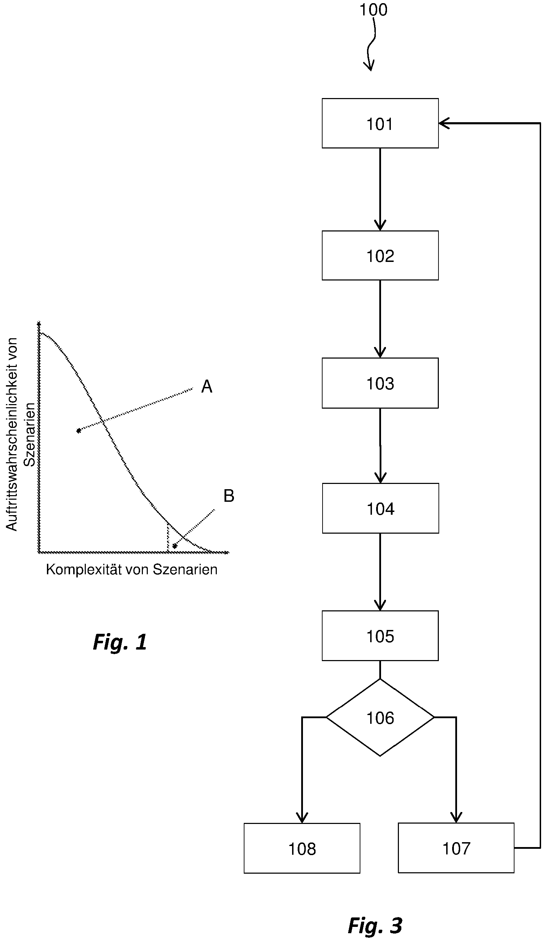

Wie in Fig. 1 dargestellt, haben solche kritischen Szenarien eine weit geringere Auftrittswahrscheinlichkeit als übliche Szenarien.

Wissenschaftliche Veröffentlichungen gehen davon aus, dass ein Betrieb eines Fahrzeugs im autonomen Fahrbetrieb nur dann statistisch sicherer als ein von Menschen gesteuertes Fahrzeug ist, wenn mit dem entsprechenden Fahrerassistenzsystem 275 Millionen Meilen unfallfreier Fahrzeit absolviert wurden, um das entsprechende Fahrerassistenzsystem zu validieren. Dies ist mittels realer Testfahrten eigentlich nicht zu realisieren, insbesondere vor dem Hintergrund, dass die Entwicklungszyklen und Qualitätsstandards, welche in der Automobilindustrie gefordert sind, schon einen sehr engen Zeitrahmen setzen. Auch wäre es unwahrscheinlich, dass eine ausreichende Menge von kritischen Szenarien bzw. sich aus diesen Szenarien ergebenden Fahrsituationen aus dem vorgenannten Grund enthalten wären.

Aus dem Stand der Technik ist es bekannt, reale Testfahrdaten einer realen Flotte von Testfahrzeugen zum Validieren und Verifizieren von Fahrerassistenzsystemen einzusetzen und aus den aufgezeichneten Daten Szenarien zu extrahieren. Des Weiteren ist es bekannt, zum Validieren und Verifizieren vollfaktorielle Versuchspläne einzusetzen.

FLORIAN HAUER ET AL: "Szenario-Optimierung fur die Absicherung von automatisierten und autonomen Fahrsystemen" offenbart eine Methodik, die eine metaheuristische Suche zur Optimierung von Szenarien einsetzt. Hierfür müssen ein geeigneter Suchraum sowie eine geeignete Fitnessfunktion erstellt werden. Ausgehend von abstrakten Beschreibungen der Systemfunktionalität und der Anwendungsfälle werden parametrisierte Szenarien abgeleitet. Die Parameter spannen einen Suchraum auf, in dem geeignete Szenarien gefunden werden müssen. Mithilfe such-basierter Techniken, die durch eine Fitnessfunktion geleitet werden, werden jene Szenarien identifiziert, in denen das System sein schlechtestes Verhalten zeigt.

DUAN JIANLI ET AL: "Test Scenario Generation and Optimization Technology for Intelligent Driving Systems" offenbart einen neuen Szenariengenerierungsalgorithmus mit der Bezeichnung Combinatorial Testing Based on Complexity (CTBC), der sowohl auf der Methode des kombinatorischen Testens (CT) als auch auf der Test-Matrix-Technik (TM) basiert und für intelligente Fahrzeugsysteme vorgesehen ist.

Es ist eine Aufgabe der Erfindung, Fahrerassistenzsysteme, insbesondere Fahrerassistenzsysteme für autonomes Fahren, in kritischen Szenarien prüfen zu können. Insbesondere ist es eine Aufgabe der Erfindung, kritische Szenarien für Fahrerassistenzsysteme zu identifizieren. Diese Aufgabe wird durch die Lehre der unabhängigen Ansprüche gelöst. Vorteilhafte Ausgestaltungen finden sich in den abhängigen Ansprüchen.

Ein erster Aspekt der Erfindung betrifft ein computerimplementiertes Verfahren zum Testen eines Fahrerassistenzsystems für ein Fahrzeug, folgende Arbeitsschritte aufweisend:
Simulieren eines Szenarios, in welchem sich das Fahrzeug befindet;
Betreiben des Fahrerassistenzsystems in einem Umfeld des Fahrzeugs auf der Grundlage des simulierten Szenarios;
Beobachten eines Fahrverhaltens des Fahrerassistenzsystems in dem Umfeld des Fahrzeugs;
Bestimmen einer Fahrsituation, welche durch das Fahrverhalten des Fahrerassistenzsystems in dem Umfeld des Fahrzeugs entsteht;
Ermitteln einer Güte des simulierten Szenarios in Abhängigkeit einer Gefährlichkeit der entstandenen Fahrsituation;
Prüfen wenigstens einer Abbruchbedingung; und
Ändern des simulierten Szenarios auf der Grundlage der ermittelten Güte, bis die wenigstens eine Abbruchbedingung in Bezug auf die Güte erfüllt ist, wobei beim Ändern des simulierten Szenarios ein neues Szenario entsteht, bei dem Parameter ausgetauscht wurden, Parameter weggelassen wurden und/oder neue Parameter hinzugekommen sind.

Ein zweiter Aspekt der Erfindung betrifft ein System zum Testen eines Fahrerassistenzsystems für ein Fahrzeug, aufweisend:
Mittel zum Simulieren eines Szenarios, in welchem sich das Fahrzeug befindet;
Mittel zum Betreiben des Fahrerassistenzsystems in einem Umfeld des Fahrzeugs auf der Grundlage des simulierten Szenarios;
Mittel zum Beobachten eines Fahrverhaltens des Fahrerassistenzsystems in dem Umfeld des Fahrzeugs;
Mittel zum Bestimmen einer Fahrsituation, welche durch das Fahrverhalten des Fahrerassistenzsystems in dem Umfeld des Fahrzeugs entsteht;
Mittel zum Ermitteln einer Güte des simulierten Szenarios in Abhängigkeit einer Gefährlichkeit der entstandenen Fahrsituation;
Mittel zum Prüfen wenigstens einer Abbruchbedingung; und
Mittel zum Ändern des simulierten Szenarios auf der Grundlage der ermittelten Güte, bis eine Abbruchbedingung in Bezug auf die Güte erfüllt ist, wobei beim Ändern des simulierten Szenario ein neues Szenario entsteht, bei dem Parameter ausgetauscht wurden, Parameter weggelassen wurden und/oder neue Parameter hinzugekommen sind.

Ein dritter Aspekt der Erfindung betrifft ein System zum Testen eines Fahrerassistenzsystems für ein Fahrzeug, einen Agenten aufweisend, wobei der Agent eingerichtet ist, um ein Szenario zu erzeugen und um einen Fehler des Fahrerassistenzsystems durch Ändern des Szenarios zu provozieren, und wobei eine Strategie zum Ändern des Szenarios mittels einer Methodik des bestärkenden Lernens durch Interaktion des Agenten mit dem Fahrerassistenzsystem während des Betreibens fortlaufend verbessert wird, bis eine Abbruchbedingung erreicht ist.

Ein Umfeld des Fahrzeugs im Sinne der Erfindung wird vorzugsweise wenigstens durch die für die Fahrzeugführung durch das Fahrerassistenzsystem relevanten Objekte gebildet. Insbesondere umfasst ein Umfeld des Fahrzeugs eine Szenerie und dynamische Elemente. Die Szenerie umfasst vorzugsweise alle stationären Elemente. Ein Szenario im Sinne der Erfindung wird vorzugsweise aus einer zeitlichen Abfolge von, insbesondere statischen, Szenen gebildet. Die Szenen geben dabei beispielsweise die räumliche Anordnung von dem wenigstens einen anderen Objekt relativ zum Ego-Objekt, z. B. die Konstellation von Verkehrsteilnehmern, an. Ein Szenario kann insbesondere eine Fahrsituation enthalten, in der ein Fahrerassistenzsystem das Ego-Fahrzeug genannte, mit dem Fahrerassistenzsystem ausgestattete Fahrzeug zumindest teilweise steuert, z. B. wenigstens eine Fahrzeugfunktion des Ego-Fahrzeugs autonom ausführt.

Eine Fahrsituation im Sinne der Erfindung beschreibt vorzugsweise die Umstände, die für die Auswahl geeigneter Verhaltensmuster des Fahrerassistenzsystems zu einem bestimmten Zeitpunkt zu berücksichtigen sind. Eine Fahrsituation ist daher vorzugsweise subjektiv, indem sie die Sicht des Ego-Fahrzeugs repräsentiert. Sie umfasst weiter vorzugsweise relevante Bedingungen, Möglichkeiten und Beeinflussungsfaktoren von Handlungen. Eine Fahrsituation weiter vorzugsweise aus der Szene durch einen Prozess der Informationsauswahl abgeleitet, basierend auf Transienten, z. B. missionsspezifischen, wie auch permanenten Zielen und Werten.

Ein Fahrverhalten im Sinne der Erfindung ist vorzugsweise ein Verhalten des Fahrerassistenzsystems durch Aktion und Reaktion in einem Umfeld des Fahrzeugs.

Eine Güte im Sinne der Erfindung charakterisiert vorzugsweise das simulierte Szenario. Unter einer Güte wird vorzugsweise eine Qualität oder Beschaffenheit des simulierten Szenarios in Bezug auf dessen Geeignetheit zum Testen des Fahrerassistenzsystems verstanden. Ein kritischeres Szenario hat hierbei vorzugsweise eine höhere Güte. Vorzugsweise ist die Gefährlichkeit einer Fahrsituation, welche aus dem jeweiligen Szenario für das getestete Fahrerassistenzsystem hervorgeht, ein Maß für die Güte des Szenarios.

Bestärkendes Lernen ist eine Methode des maschinellen Lernens, bei der ein Agent selbstständig Tätigkeiten in einer Umgebung erlernt. Dies geschieht dadurch, dass der Agent verschiedenen Aktionen in einer Umgebung probiert und durch Rückmeldung der Umgebung entweder eine Belohnung oder eine Strafe er-hält. Nach einer Lernphase ist der Agent in der Lage in der Umgebung eine Tätigkeit auszuführen, sodass er dafür die größtmögliche Belohnung erhält.

Ein Agent im Sinne der Erfindung bezeichnet vorzugsweise ein Computerprogramm oder ein Modul einer Datenverarbeitungsanlage, das zu gewissem eigenständigem und eigendynamischem, insbesondere autonomem, Verhalten fähig ist. Das bedeutet, dass abhängig von verschiedenen Zuständen, insbesondere verschiedenen Status, ein vorbestimmter Verarbeitungsvorgang abläuft, ohne dass von außen ein weiteres Startsignal gegeben wird oder während des Vorgehens ein äußerer Steuerungseingriff erfolgt.

Die Erfindung basiert auf der Idee, simulierte Szenarien iterativ in der Weise zu verbessern, dass sie sich möglichst gut zum Testen eines Fahrerassistenzsystems eignen. Mit anderen Worten werden die simulierten Szenarien in der Weise verbessert, dass sie sich möglichst gut eignen, einen möglichen Fehler im Fahrerassistenzsystem aufzudecken oder hervorzurufen. Hierdurch werden simulierte Szenarien speziell auf ein bestimmtes Fahrerassistenzsystem oder eine Funktion eines Fahrerassistenzsystems hin optimiert.

Vorzugsweise kann vorgesehen sein, dass eine Abbruchbedingung vorhanden ist, bei deren Erreichen der iterative Prozess abgebrochen wird. Wird deine solche Abbruchbedingung nicht erreicht, kann als weitere Abbruchbedingung beispielsweise eine maximale Testzeit oder auch eine maximale Anzahl an zurückgelegten Testkilometern, welche das Fahrzeug in den simulierten Szenarien absolviert hat, vorgesehen sein. Die Güte des simulierten Szenarios, also jene Größe, welche die simulierten Szenarien bewertet, hängt vorzugsweise von einem definierten Kriterium in Bezug auf eine jeweils in jedem Iterationsschritt entstandene Fahrsituation ab.

Als Kriterium kann hierbei insbesondere die Gefährlichkeit der Fahrsituation als Maß für die Güte herangezogen werden. Weiter vorzugsweise ist dieses Maß für die Güte eine berechnete Dauer bis zu einem Kollisionszeitpunkt, eine Unfallwahrscheinlichkeit, und/oder ein nicht adäquates Fahrverhalten des Fahrerassistenzsystems. Ein solches nicht adäquates Fahrverhalten kann z. B. ein Bruch einer Verkehrsregel und/oder ein Manöver mit einem übermäßigen Risiko für Schäden, insbesondere Personenschäden, aufweisen.

Die Erfindung verfolgt dabei einen Ansatz eines Spiels mit zwei "Spielern", wobei das Verfahren oder das System zum Testen des Fahrerassistenzsystems versuchen, iterativ Szenarien mit sich vergrößernder Komplexität zu erzeugen, bis ein vordefiniertes Kriterium, insbesondere eine (sicherheits-)kritische Metrik in Bezug auf die Fahrerassistenzsystemfunktionalität, verletzt wird. In diesem Fall hat das Verfahren bzw. System zum Testen "gewonnen". Wird eine solche Verletzung, also das Erreichen einer Abbruchbedingung, nicht hervorgerufen, so "gewinnt" dagegen das getestete Fahrerassistenzsystem.

Mittels der Erfindung kann die Anzahl an Streckenkilometern zum Testen eines Fahrerassistenzsystems wesentlich reduziert werden, da die Erfindung intuitiv jene Szenarien findet, welche für das jeweilige Fahrerassistenzsystem besonders kritisch sind. Der Großteil an Szenarien kann im Normalfall von dem jeweiligen Fahrerassistenzsystem einfach bewältigt werden. In diesem Fall können aber auch keine Schwachstellen des Fahrerassistenzsystems aufgedeckt werden.

Während des Testverfahrens lernt ein sogenannter Agent, welcher vorzugsweise als Softwaremodul oder Unteralgorithmus in dem Testverfahren ausgebildet sein kann, von dem Verhalten des getesteten Fahrerassistenzsystems und verbessert kontinuierlich die Güte des simulierten Szenarios um eine Fehlfunktion des untersuchten Fahrerassistenzsystems hervorzurufen.

Das Testverfahren wird dabei iterativ wiederholt, bis ein Ändern des simulierten Szenarios zu einem Verhalten des Fahrerassistenzsystems führt, welches einen vordefinierten Zielwert, welcher als Abbruchbedingung dient, verletzt wird. Eine solche Abbruchbedingung kann z. B. eine Dauer bis zu einem Kollisionszeitpunkt von weniger als 0,25 Sekunden oder auch ein bestimmtes Zeitbudget, z. B. 600 Stunden maximale Simulationszeit sein.

Unter einer Annahme eines ausreichend langen Zeitbudgets kann mittels der Erfindung eine hohe Wahrscheinlichkeit erreicht werden, dass das ADAS oder AD-System korrekt funktioniert. Die Aussagekraft des Mittels der erfindungsgemäßen Lehre durchgeführten Tests hängt dabei von jenem Algorithmus ab, welcher zum Ändern der simulierten Szenarien eingesetzt wird. Idealerweise weist ein solcher Algorithmus eine menschenartige Intuition auf, durch die ein jeweiliges Fahrerassistenzsystem an seine Grenzen gebracht werden kann.

In einer vorteilhaften Ausgestaltung des Verfahrens zum Testen eines Fahrerassistenzsystems wird beim Simulieren des Szenarios eine Geschwindigkeit, insbesondere eine initiale Geschwindigkeit, des Fahrzeugs und/oder eine Trajektorie des Fahrzeugs vorgegeben. Auf diese Weise können Erfahrungswerte bei einem Test berücksichtigt werden. Auf diese Weise kann ein Agent bereits auf eine richtige Fährte gesetzt werden, um ein kritisches Szenario zu entwickeln.

In einer weiteren vorteilhaften Ausgestaltung des Verfahrens zum Testen eines Fahrerassistenzsystems werden beim Ändern des simulierten Szenarios Werte von Parametern eines Szenarios verändert. In diesem Fall wird das jeweils bestehende Szenario iterativ angepasst und auf diese Weise zum Testen des jeweiligen Fahrerassistenzsystems verbessert. Diese Vorgehensweise ist insbesondere dann von Vorteil, wenn ein bestimmtes Szenario zum Testen eines bestimmten Fahrerassistenzsystems "optimiert" werden soll.

In einer weiteren vorteilhaften Ausgestaltung des Verfahrens zum Testen eines Fahrerassistenzsystems sind die Parameter des Szenarios, je nach Art des zu testenden Fahrerassistenzsystems, aus der folgenden Gruppe ausgewählt:
Geschwindigkeit, insbesondere eine initiale Geschwindigkeit, des Fahrzeugs; Trajektorie des Fahrzeugs; Lichtverhältnisse; Witterung; Fahrbahnbeschaffenheit; Anzahl und Position statischer und/oder dynamischer Objekte; Geschwindigkeit und Bewegungsrichtung der dynamischen Objekte; Zustand von Signalanlagen, insbesondere von Lichtsignalanlagen; Verkehrszeichen; vertikale Elevation, Breite und/oder Befahrbarkeit von Fahrspuren, Fahrspurenverlauf, Anzahl der Fahrspuren.

In einer weiteren vorteilhaften Ausgestaltung des Verfahrens zum Testen eines Fahrerassistenzsystems entsteht beim Ändern des simulierten Szenarios ein neues Szenario, welches vorzugsweise aus hintereinander kombinierten Szenarien besteht. Ein neues Szenario wird vorzugsweise dadurch charakterisiert, dass neue Fahraufgaben bewältigt werden müssen. Beispielsweise ist das Szenario des Anfahrens einer Kreuzung ganz grundsätzlich von dem Szenario des Fahrens auf der Autobahn zu unterscheiden.

Das Ersetzen von simulierten Szenarien durch neue Szenarien bietet den Vorteil, dass mit einem Fahren zum Testen viele unterschiedliche Fahrsituationen abgedeckt werden können und viele Funktionen des Fahrerassistenzsystems in einem ganz unterschiedlichen Umfeld getestet werden können. Dies erhöht in ganz wesentlichem Maße die Aussagekraft des Testverfahrens. Beim Erschaffen eines neuen Szenarios können zum Ändern von Werten von Parametern insbesondere auch ganz neue Parameter vorgesehen sein.

In einer weiteren vorteilhaften Ausgestaltung des Verfahrens zum Testen eines Fahrerassistenzsystems wird beim Ermitteln der Güte eine fiktive Belohnung gutgeschrieben und das Verändern erfolgt auf der Grundlage einer Funktion, welche ausgestaltet ist, um die Belohnung zu maximieren. Vorzugsweise lernt der bei der Erfindung jeweils eingesetzte Algorithmus, insbesondere ein Agent, welcher diesen Algorithmus anwendet, welche Veränderungen an dem bestehenden simulierten Szenario oder welche Änderungen zu einem neuen Szenario zum Erreichen des erwünschten Effekts zielführend sind, d. h. welche Änderungen zu kritischen Szenarien führen und gegebenenfalls eine Fehlfunktion des Fahrerassistenzsystems oder einen Unfall provozieren.

In einer weiteren vorteilhaften Ausgestaltung des Verfahrens zum Testen eines Fahrerassistenzsystems ist die Güte höher, je gefährlicher die jeweils entstandene Fahrsituation ist, insbesondere je kürzer eine berechnete Dauer bis zu einem Kollisionszeitpunkt ist.

In einer weiteren vorteilhaften Ausgestaltung wird das Verändern des simulierten Szenarios unter Verwendung evolutionärer Algorithmen vorgenommen. Evolutionäre Algorithmen werden auch als genetische Algorithmen bezeichnet. Beim Verändern solcher Algorithmen werden verschiedene Algorithmen gekreuzt und mutiert. Aus den so entstehenden Algorithmen werden Kandidaten für den nächsten Iterationsschritt gebildet.

Diese Auswahl kann so erfolgen, dass jene Kandidaten ausgewählt werden, für welche die höchste Wahrscheinlichkeit besteht, dass sie kritische Szenarien hervorrufen. Genetische evolutionäre Algorithmen bieten hierbei ein hohes Maß an Flexibilität, um bestehende Szenarien in Bezug auf vordefinierte Kriterien zu optimieren.

In einer weiteren vorteilhaften Ausgestaltung des Verfahrens zum Testen eines Fahrerassistenzsystems wird auf der Grundlage der ermittelten Güte eine Nutzenfunktion approximiert, welche beschreibt, welchen Wert ein bestimmtes Szenario hat. Der Algorithmus oder der Agent sieht diesen Wert des simulierten Szenarios als eine Art Belohnung an und ist vorzugsweise in der Weise konfiguriert, um den Wert und die Belohnung damit zu maximieren.

In einer weiteren vorteilhaften Ausgestaltung des Verfahrens zum Testen eines Fahrerassistenzsystems wird das Fahrerassistenzsystem simuliert. Ein Simulieren des Fahrerassistenzsystems ist besonders vorteilhaft, da in diesem Fall kein Prüfstand zum Testen der realen Komponenten eines realen Fahrerassistenzsystems notwendig ist. Insbesondere kann in diesem Fall das erfindungsgemäße Verfahren schneller als Echtzeit ausgeführt werden. Die Geschwindigkeit der Simulation ist dabei lediglich von der bereitgestellten Rechenleistung begrenzt.

In einer weiteren vorteilhaften Ausgestaltung des erfindungsgemäßen Verfahrens zum Testen eines Fahrerassistenzsystems ist eine Strategie zum Ändern des Szenarios mittels einer Methodik des bestärkenden Lernens auf der Grundlage der ermittelten Güte während des Testbetriebs fortlaufend verbessert, bis die Abbruchbedingung erreicht ist. Beim Einsatz von bestärkendem Lernen, im Englischen auch "reinforcement learning" genannt, erlernt ein Algorithmus bzw. der Agent selbstständig eine Strategie, um eine erhaltene Belohnung zu maximieren. Hierfür können für vorgenommene Aktionen sowohl positive als auch negative Belohnungen vergeben werden. Der Einsatz von bestärkendem Lernen erlaubt eine besonders effektive Optimierung der simulierten Szenarien.

In einer weiteren vorteilhaften Ausgestaltung des Verfahrens zum Testen eines Fahrerassistenzsystems werden beim initialen Simulieren des Szenarios historische Daten aus früheren Testbetrieben eines Fahrerassistenzsystems, insbesondere des Fahrerassistenzsystems berücksichtigt. Die Nutzung von historischen Daten kann zum Vortrainieren des Algorithmus oder des Agenten genutzt werden. Hierdurch kann die Dauer bis zum Auffinden von kritischen Szenarien reduziert werden. Des Weiteren können auch Algorithmen oder Agenten eingesetzt werden, welche auf einem anderen, insbesondere ähnlichen, ADAS bzw. AD-System trainiert wurden. Insbesondere können auf diese Weise sogenannte Regressionstests ausgeführt werden, um sicherzustellen, dass Änderungen in bereits getesteten Teilen der Software des Fahrerassistenzsystems keine neuen Fehler verursachen.

In einer weiteren vorteilhaften Ausgestaltung des Verfahrens zum Testen eines Fahrerassistenzsystems werden beim Betreiben des Fahrerassistenzsystems Daten in Bezug auf das Umfeld des Fahrzeugs in das Fahrerassistenzsystem eingespeist und/oder das Fahrerassistenzsystem, insbesondere die Sensoren, werden auf der Grundlage des Umfelds des Fahrzeugs stimuliert. In diesem Fall kann das erfindungsgemäße Verfahren verwendet werden, um ein physisch vorhandenes Fahrerassistenzsystem zu testen. Vorzugsweise wird dabei das Fahrzeug simuliert. Grundsätzlich ist jedoch auch denkbar, dass das gesamte Fahrzeug samt Fahrerassistenzsystem auf einem Prüfstand in der Weise getestet wird. Diese Ausgestaltung bietet den Vorteil, dass das Fahrerassistenzsystem mit all seinen Komponenten unter möglichst realen Bedingungen getestet werden kann.

In einer vorteilhaften Ausgestaltung des Systems zum Testen eines Fahrerassistenzsystems ist der Agent eingerichtet, um eine Fahrsituation, welche durch ein Fahrverhalten des Fahrerassistenzsystems in einem Umfeld des Fahrzeugs auf der Grundlage des simulierten Szenarios entsteht, zu beobachten und eine Güte des Szenarios in Abhängigkeit einer Gefährlichkeit der entstandenen Fahrsituation zu ermitteln.

In einer weiteren vorteilhaften Ausgestaltung des Systems zum Testen eines Fahrerassistenzsystems ist der Agent auf der Grundlage von historischen Daten vortrainiert. Diese Daten werden beim initialen Simulieren des Szenarios durch den Agenten berücksichtigt.

Die im Vorhergehenden beschriebenen Merkmale und Vorteile in Bezug auf den ersten Aspekt der Erfindung gelten entsprechend auch für den zweiten und dritten Aspekt der Erfindung und umgekehrt.

Weitere Merkmale und Vorteile ergeben sich aus der nachfolgenden Beschreibung in Bezug auf die Figuren. Es zeigen wenigstens teilweise schematisch:
**Figur 1** ein Diagramm der Auftrittswahrscheinlichkeit von Szenarien in Abhängigkeit ihrer Komplexität;
**Figur 2a** ein Beispiel eines Szenarios;
**Figur 2b** ein Beispiel eines Szenarios mit höherer Komplexität als jenes aus Figur 2a;
**Figur 3** ein Ausführungseispiel eines Verfahrens zum Testen eines Fahrerassistenzsystems; und
**Figur 4** ein Ausführungsbeispiel eines Systems zum Testen eines Fahrerassistenzsystems.

**Figur 1** zeigt die Auftrittswahrscheinlichkeit von Szenarien in Abhängigkeit der Komplexität von Szenarien. Die Auftrittswahrscheinlichkeit ist jene Wahrscheinlichkeit, mit welcher Szenarien im realen Straßenverkehr vorkommen.

In Fig. 1 fällt auf, dass die Mehrzahl an Szenarien von relativ geringer Komplexität ist, was auch der allgemeinen Lebenserfahrung eines Autofahrers entspricht. Der Bereich dieser Szenarien ist in Fig. 1 mit "A" bezeichnet. Szenarien von hoher Komplexität, deren Bereich in Fig. 1 mit "B" bezeichnet ist, kommen dagegen relativ selten vor. Gerade jene Szenarien "B" mit großer Komplexität sind jedoch zum Untersuchen der Funktionstüchtigkeit von Fahrerassistenzsystemen von hoher Relevanz.

Um eine ausreichende Anzahl und Diversität an verschiedenen Szenarien mit hoher Komplexität "B" während des Tests eines Fahrerassistenzsystems zu erreichen, muss daher, unter Zugrundelegung der gezeigten Verteilungskurve, eine sehr hohe Anzahl an Szenarien durchlaufen werden.

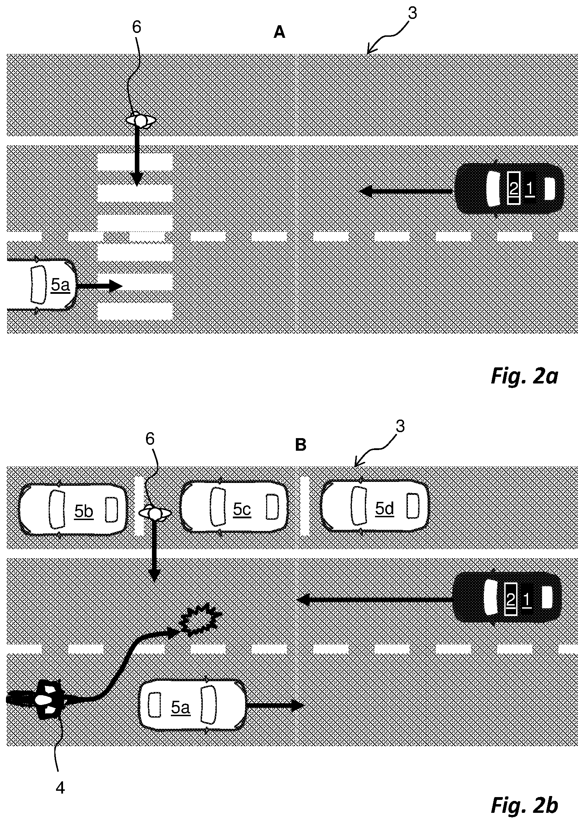

**Figur 2a** zeigt ein erstes Szenario 3, bei welchem ein Fußgänger 6 einen Zebrastreifen überquert und ein durch ein Fahrerassistenzsystem 2 gesteuertes Fahrzeug 1 sowie ein weiteres Fahrzeug 5a auf der Gegenspur sich dem Zebrastreifen nähern. Das Fahrerassistenzsystem 2 steuert dabei sowohl die longitudinale wie auch die laterale Bewegung des Fahrzeugs 1.

Bei dem in Fig. 2 gezeigten ersten Szenario 3 sind sowohl der Fußgänger 6, als auch der Straßenverlauf, der Zebrastreifen und das entgegenkommende andere Fahrzeug 5a für das Fahrerassistenzsystem 2 mittels Sensoren gut einsehbar. Im dargestellten Beispiel wird das Fahrerassistenzsystem 2 erkennen, dass es die Fahrzeuggeschwindigkeit reduzieren muss, um den Fußgänger 6 auf dem Zebrastreifen passieren lassen zu können. Die Bewegung des anderen Fahrzeugs 5a spielt hierbei voraussichtlich keine Rolle. Figur 2a betrifft mithin ein Szenario 3 mit vergleichsweise niedriger Komplexität.

In dem zweiten Szenario 3, welches in **Fig. 2b** dargestellt ist, existiert kein Zebrastreifen. Darüber hinaus sind neben dem Fahrstreifen des durch das Fahrerassistenzsystem 2 gesteuerten Fahrzeugs 1 weitere Fahrzeuge 5b, 5c, 5d geparkt, durch welche der Fußgänger 6 für die Sensoren des Fahrerassistenzsystems 2 nicht oder nur schlecht erfassbar ist.

Neben dem Fußgänger 6 und den geparkten Fahrzeugen 5b, 5c, 5d befindet sich im Umfeld des durch das Fahrerassistenzsystem 2 gesteuerten Fahrzeugs 1 ein weiteres Fahrzeug 5a, welches, wie in Figur 2a, dem durch das Fahrerassistenzsystem 2 gesteuerten Fahrzeug 1 entgegenkommt.

Hinter diesem weiteren Fahrzeug 5a fährt ein Motorradfahrer 4. Ob dieser im Umfeld des durch das Fahrerassistenzsystem 2 gesteuerten Fahrzeugs 1 wahrnehmbar ist, lässt sich aus Figur 2b nicht deuten. In dem dargestellten Szenario 3 wird der Motorradfahrer 4 versuchen, das weitere Fahrzeug 5a auf der anderen Fahrspur zu überholen. Gleichzeitig wird der Fußgänger 6 in dem dargestellten Szenario versuchen, die Straße zu überqueren. Hierbei nimmt er von dem durch das Fahrerassistenzsystem 2 gesteuerten Fahrzeug 1 keine Kenntnis.

Je nachdem, wie das Fahrerassistenzsystem 2 in dem Szenario 3 reagiert oder agiert, d. h., welches Fahrverhalten das Fahrerassistenzsystem 2 in dem Umfeld des Fahrzeugs 1 zeigt, wird sich eine Fahrsituation ergeben, die gefährlich oder weniger gefährlich ist. Wird das Fahrzeug 2 beispielsweise, wie in Figur 2b durch die Pfeile angedeutet, in dem gezeigten Szenario 3 mit unverminderter Geschwindigkeit weiterfahren, so wird es wahrscheinlich zu einer Kollision zwischen dem durch das Fahrerassistenzsystem 2 gesteuerten Fahrzeug 1 und dem Motorrad 4 kommen. Eine solche Fahrsituation würde einer sehr hohen Gefährlichkeit entsprechen.

Aufgrund der hohen Menge an Informationen, welche das Fahrerassistenzsystem 2 des Fahrzeugs 1 in dem in Figur 2b gezeigten Szenario 3 verarbeiten muss und der möglichen Probleme, welche sich aus der Konstellation an Verkehrsteilnehmern 5a, 5b, 5c, 5d ergeben kann, welche für das Fahrerassistenzsystem 2 im Umfeld sichtbar sind, weist das zweite Szenario 3 nach Figur 2b eine vergleichsweise hohe Komplexität, insbesondere im Vergleich zu dem in Figur 2a gezeigten ersten Szenario auf.

**Figur 3** zeigt ein Ausführungsbeispiel eines Verfahrens 100 zum Testen eines Fahrerassistenzsystems für ein Fahrzeug 1.

In einem ersten Arbeitsschritt 101 wird ein Szenario 3, in welchem sich das Fahrzeug 1 befindet, simuliert. Vorzugsweise wird dabei einerseits das Umfeld des Fahrzeugs 1 mit allen dynamischen Elementen, in Fig. 2b beispielsweise der Fußgänger 6, das weitere Fahrzeug 5a und das Motorrad 4, sowie mit stationären Elementen, in Fig. 2b die weiteren Fahrzeuge 5b, 5c, 5d und die Straße, simuliert.

Auf der Grundlage dieser Simulation kann ein Fahrerassistenzsystem 2, gegebenenfalls zusammen mit dem von diesem gesteuerten Fahrzeug 1, vorzugsweise in einem Prüfstand 12 simuliert werden. Die Sensoren des Fahrerassistenzsystems 2 werden in diesem Fall vorzugsweise in der Weise stimuliert, um das simulierte Szenario 3 bzw. das Umfeld des Fahrzeugs 1, welches sich durch dieses simulierte Szenario 3 ergibt, nachzubilden. Hierfür werden insbesondere geeignete Stimulatoren verwendet, wie sie aus dem Stand der Technik bekannt sind.

Weiter vorzugsweise kann das Fahrerassistenzsystem 2 oder lediglich die Software des Fahrerassistenzsystems 2 in der Art eines Hardware-in-the-Loop-Tests in die Simulation des Szenarios 3 eingebunden sein.

Schließlich ist es auch möglich, das Fahrerassistenzsystem 2 oder auch lediglich die Software des Fahrerassistenzsystems 2 zu simulieren.

Weiter vorzugsweise wird beim Simulieren des Szenarios eine Geschwindigkeit, insbesondere eine initiale Geschwindigkeit des Fahrzeugs 1 und/oder eine Trajektorie des Fahrzeugs 1 vorgegeben. Des Weiteren vorzugsweise können beim Simulieren des Szenarios historische Daten aus früheren Testbetrieben entweder des getesteten Fahrerassistenzsystems 2 oder anderer Fahrerassistenzsysteme berücksichtigt werden. Diese historischen Daten sind insbesondere beim Bestimmen eines initialen simulierten Testszenarios dienlich. Des Weiteren vorzugsweise können solche historischen Daten zum Trainieren eines sogenannten Agenten verwendet werden, welcher das Fahrerassistenzsystem testet oder es kann ein Agent verwendet werden, welcher bereits zum Testen eines, insbesondere anderen, Fahrerassistenzsystems eingesetzt wurde.

In einem zweiten Arbeitsschritt 102 wird das Fahrerassistenzsystem 2 in dem Umfeld des Fahrzeugs auf der Grundlage des simulierten Szenarios 3 betrieben. Wird auch das Fahrerassistenzsystem 2 lediglich simuliert, so wird auch der Betrieb des Fahrerassistenzsystems 2 in dem Umfeld des durch das Fahrerassistenzsystem 2 gesteuerten Fahrzeugs 1 lediglich simuliert.

In einem dritten Arbeitsschritt 103 wird das Fahrverhalten des Fahrerassistenzsystems 2 in dem Umfeld des durch das Fahrerassistenzsystem 2 Fahrzeugs 1 beobachtet.

Auf der Grundlage der durch das Beobachten ermittelten Daten kann zu jedem Zeitpunkt eine Fahrsituation bestimmt werden, welche durch das Fahrverhalten des Fahrerassistenzsystems 2 in dem Umfeld des Fahrzeugs 1 entstanden ist. Dies wird vorzugsweise in einem vierten Arbeitsschritt 100 durchgeführt.

Aufgrund der entstandenen Fahrsituation muss das Fahrerassistenzsystem 2 neuerliche Entscheidungen treffen, wie es sich verhält und das durch dieses gesteuerte Fahrzeug 1 steuert.

In dem simulierten Szenario 3 kann die jeweils entstandene Fahrsituation in Bezug auf die Gefährlichkeit objektiv untersucht werden. Insbesondere kann auf der Grundlage der durch das Szenario 3 verfügbaren Informationen zu jedem Zeitschritt der Simulation eine Unfallwahrscheinlichkeit, eine Dauer bis zu einem Kollisionszeitpunkt berechnet werden.

In dem Szenario 3 der Figur 2b könnte beispielsweise die Dauer bis zum Kollisionszeitpunkt berechnet werden, wenn das von dem Fahrerassistenzsystem 2 gesteuerte Fahrzeug 1 mit unverminderter Geschwindigkeit geradeaus weiterfährt.

Die Unfallwahrscheinlichkeit kann beispielsweise durch eine Bewertung der Adäquatheit des Fahrverhaltens des Fahrerassistenzsystems 2 beeinflusst werden. Eine Unfallwahrscheinlichkeit in dem Szenario 3 von Fig. 2 a oder Fig. 2b wäre beispielsweise erhöht, wenn das durch das Fahrerassistenzsystem 2 gesteuerte Fahrzeug 1 mit stark überhöhter Geschwindigkeit fährt.

In einem fünften Arbeitsschritt 105 wird die Güte des simulierten Szenarios 3 in Abhängigkeit eines vordefinierten Kriteriums in Bezug auf die entstandene Fahrsituation ermittelt. Die Güte ergibt sich dabei insbesondere aus der Komplexität des simulierten Szenarios, wobei eine höhere Komplexität des simulierten Szenarios 3 auf eine höhere Güte hindeutet. Vorzugsweise gibt die Güte dabei an, wie die durch das Fahrverhalten des Fahrerassistenzsystems 2 entstandene Fahrsituation in Bezug auf ein vordefiniertes Kriterium zu beurteilen ist. Ein solches Kriterium kann beispielsweise die Gefährlichkeit der entstandenen Fahrsituation sein, welche durch die Unfallwahrscheinlichkeit und/oder eine Zeitdauer bis zu einem möglichen Kollisionszeitpunkt charakterisiert ist. Des Weiteren kann die Gefährlichkeit auch durch eine Wahrscheinlichkeit eines nicht adäquaten Fahrverhaltens des Fahrerassistenzsystems 2 charakterisiert sein.

Nun wird in einem sechsten Arbeitsschritt 106 geprüft, ob eine Abbruchbedingung erfüllt ist. Eine solche Abbruchbedingung kann einerseits durch ein vordefiniertes Kriterium in Bezug auf die entstandene Fahrsituation definiert sein, beispielsweise ein Grenzwert für eine maximale Zeitdauer bis zu einem Kollisionszeitpunkt oder auch eine maximale Unfallwahrscheinlichkeit. Als weitere Abbruchbedingung kann auch eine maximale Testzeit zusätzlich vorgegeben werden.

Wird die Abbruchbedingung erreicht, so werden das simulierte Szenario bzw. die Parameterwerte des simulierten Szenarios und/oder die Güte des simulierten Szenarios in einem achten Arbeitsschritt 108 ausgegeben, insbesondere in Form eines Testberichts.

Wird die Abbruchbedingung nicht erreicht, so folgt in einem siebten Arbeitsschritt 107 ein Ändern des simulierten Szenarios 3 auf der Grundlage der ermittelten Güte. Hier beginnt das Testverfahren wiederum von vorn bei dem ersten Arbeitsschritt 101. Die Arbeitsschritte werden iterativ vorzugsweise so lange ausgeführt, bis wenigstens eine der Abbruchbedingungen erreicht ist.

Zum Ändern des simulierten Szenarios im siebten Arbeitsschritt 107 gibt es grundsätzlich zwei verschiedene Herangehensweisen. Zum einen können ausschließlich Werte von Parametern des simulierten Szenarios verändert werden. In diesem Fall baut das geänderte simulierte Szenario stets auf dem im vorhergehenden Iterationsschritt verwendeten simulierten Szenario auf. Diese Vorgehensweise wird insbesondere dann angewandt, wenn das simulierte Szenario 3 mittels sogenannter evolutionärer Algorithmen geändert wird.

Alternativ entsteht beim Ändern des simulierten Szenarios ein neues Szenario. In einem solchen neuen Szenario können insbesondere Parameter ausgetauscht werden, Parameter weggelassen und/oder neue Parameter hinzukommen.

Diese Vorgehensweise wird insbesondere dann eingesetzt, wenn für die Strategie zum Ändern des Szenarios eine Methodik des bestärkenden Lernens auf der Grundlage der ermittelten Güte eingesetzt wird. Beim bestärkenden Lernen wird diese Strategie während des Testbetriebs laufend verbessert, bis die Abbruchbedingung erreicht ist. Vorzugsweise wird in diesem Fall auf der Grundlage der ermittelten Güte eine Nutzenfunktion approximiert, welche beschreibt, welchen Güte-Wert ein bestimmtes simuliertes Szenario hat.

Wie bereits erwähnt, kann jener Algorithmus, welcher die Szenarien ändert, vorzugsweise als sogenannter Agent ausgebildet sein. In diesem Fall ähnelt das Testverfahren einem Spiel mit zwei Spielern, wobei der Agent gegen das Fahrerassistenzsystem 2 spielt, um einen Fehler des Fahrerassistenzsystems 2 zu provozieren.

Vorzugsweise ist die Güte durch eine fiktive Belohnung charakterisiert und das Verändern erfolgt auf der Grundlage einer Kostenfunktion bzw. einer Optimierung der Kostenfunktion. Vorzugsweise ist die Kostenfunktion ausgestaltet, um die fiktive Belohnung zu maximieren. Die Güte ist vorzugsweise umso höher, je gefährlicher die jeweils entstandene Fahrsituation ist, insbesondere je kürzer eine berechnete Dauer bis zu einem Kollisionszeitpunkt ist.

Ein Workflow, welcher ein Verfahren zum Testen eines Fahrerassistenzsystems umfasst, kann des Weiteren die folgenden Arbeitsschritte aufweisen: In einem ersten weiteren Arbeitsschritt wird das Fahrerassistenzsystem, welches getestet wird, zusammen mit einem geeigneten Fahrzeugdynamikmodell, z. B. VSM ^{®}, in eine geeignete Modellierungs- und Integrationsplattform, z. B. MobiConnect ^{®}, integriert. Auf dieser Integrationsplattform wird auch eine 3D-Simulationsumgebung vorzugsweise bereitgestellt.

In einem zweiten weiteren Arbeitsschritt wird ein Scenario Template erstellt, welches generisch die Straßeneigenschaften, z. B. mittels OpenDRIVE ^{®}, Verkehrsteilnehmer und Fahrzeugmanöver, z. B. mittels OpenSCENARIO ^{®}, beschreibt. Optional können virtuelle Szenarien auf der Grundlage von Daten aus einem realen Fahrbetrieb zum Erzeugen herangezogen werden. Hierfür eignen sich z. B. GPS-Daten, Sensordaten, Objektlisten, etc.

In einem dritten weiteren Arbeitsschritt werden jene Parameter identifiziert und ausgewählt, mit welchen ein Algorithmus zum Ändern von Szenarien die Szenarien ändern kann. Für diese Parameter werden danach Wertebereiche definiert, in welchen diese Parameter sich bewegen können. Zum Beispiel könnte vorgegeben werden, dass der Algorithmus kontinuierlich Werte zwischen 5 und 35 m/s für den Szenario-Parameter "Fahrzeuggeschwindigkeit des vorhergehenden Fahrzeugs" vergeben kann. Vorzugsweise können hier nicht nur Parameter in Bezug auf die Umgebung des durch das Fahrerassistenzsystem 2 gesteuerte Fahrzeugs 1 gewählt werden, sondern auch Trajektorien des Fahrzeugs 1 können zur Veränderung durch den Algorithmus ausgewählt werden. Auch für andere Verkehrsteilnehmer können Trajektorien als Parameter verändert werden. Für jeden Verkehrsteilnehmer werden dabei individuelle Trajektorien durch Wegpunkte und Zeitschritte festgelegt. Die Trajektorien können dann durch Verändern der Position der Wegpunkte und des Abstands der Wegpunkte voneinander verändert werden.

In einem vierten weiteren Arbeitsschritt werden spezifische Kriterien vordefiniert, welche zum Steuern der iterativen Erzeugung von Szenarien dienen. Ist das vordefinierte Kriterium die Zeitdauer bis zu einem Kollisionszeitpunkt, so wird der Algorithmus versuchen, diese Zeitdauer zu minimieren und nach Parameterwerten in den Szenarien suchen, welche zu einem Unfall führen.

In einem fünften weiteren Arbeitsschritt werden geeignete Abbruchbedingungen definiert. Eine mögliche Abbruchbedingung ist beispielsweise, dass die Zeitdauer bis zu einem Kollisionszeitpunkt 0,25 Sekunden beträgt oder dass eine maximale Anzahl an Iterationen erreicht ist.

In einem weiteren sechsten Arbeitsschritt wird ein anfänglicher Satz an Parameterwerten erzeugt. Diese werden zufällig erzeugt, manuell ausgewählt, auf der Grundlage von realen Testfahrten ausgewählt. Zusammen mit dem bereits erzeugten Scenario Template können auf diese Weise konkrete Szenarien erzeugt werden, welche in der 3D-Simulation ausgeführt werden können.

Hierauf kann das Verfahren zum Testen eines Fahrerassistenzsystems, wie oben beschrieben, ausgeführt werden.

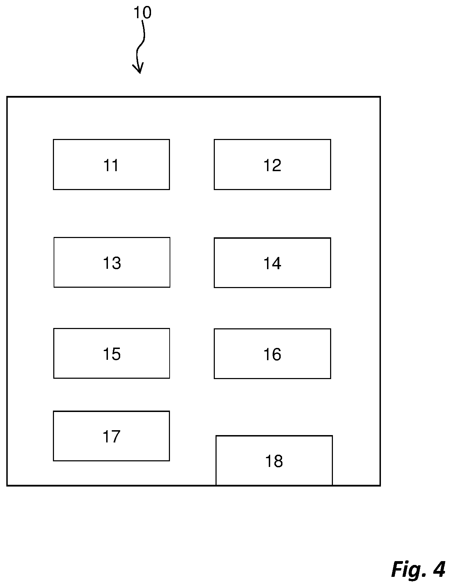

**Figur 4** zeigt ein Ausführungsbeispiel eines Systems zum Testen eines Fahrerassistenzsystems.

Dieses System 10 weist vorzugsweise Mittel 11 zum Simulieren eines Szenarios, in welchem sich das Fahrzeug 1 befindet, Mittel 12 zum Betreiben des Fahrerassistenzsystems 2 in einem Umfeld des Fahrzeugs 1 auf der Grundlage des simulierten Szenarios, Mittel 13 zum Beobachten eines Fahrverhaltens des Fahrerassistenzsystems 2 in dem Umfeld des Fahrzeugs 1, Mittel 14 zum Bestimmen einer Fahrsituation, welche durch das Fahrverhalten des Fahrerassistenzsystems 2 in dem Umfeld des Fahrzeugs entsteht, Mittel 15 zum Ermitteln einer Güte des Simulierten Szenarios 3 in Abhängigkeit eines vordefinierten Kriteriums in Bezug auf die Fahrsituation, insbesondere einer Gefährlichkeit der entstandenen Fahrsituation, Mittel zum Prüfen einer Abbruchbedingung 16 und Mittel 17 zum Ändern des simulierten Szenarios 3 auf der Grundlage der ermittelten Güte, bis eine Abbruchbedingung erreicht ist, auf.

Vorzugsweise sind die vorgenannten Mittel durch eine Datenverarbeitungsanlage gebildet. Das Mittel 12 zum Betreiben des Fahrerassistenzsystems in einem Umfeld des Fahrzeugs 1 kann jedoch auch durch einen Prüfstand, insbesondere einen Prüfstand für ein Fahrerassistenzsystem oder ein Fahrzeug, gebildet werden. In diesem Fall können die Mittel 13 zum Beobachten eines Fahrverhaltens des Fahrerassistenzsystems 2 jedenfalls teilweise durch Sensoren gebildet sein.

Die Mittel 17 zum Ändern des simulierten Szenarios können vorzugsweise als Agent ausgebildet sein.

Vorzugsweise weist das System eine Schnittstelle 18 auf, welche vorzugsweise als Benutzerschnittstelle oder als Datenschnittstelle ausgebildet sein kann.

Es wird darauf hingewiesen, dass es sich bei den Ausführungsbeispielen lediglich um Beispiele handelt, die den Schutzbereich, die Anwendung und den Aufbau in keiner Weise einschränken sollen. Vielmehr wird dem Fachmann durch die vorausgehende Beschreibung ein Leitfaden für die Umsetzung mindestens eines Ausführungsbeispiels gegeben, wobei diverse Änderungen, insbesondere im Hinblick auf die Funktion und Anordnung der beschriebenen Bestandteile, vorgenommen werden können, ohne den Schutzbereich zu verlassen, wie er sich aus den Ansprüchen und diesen äquivalenten Merkmalskombinationen ergibt.

### Bezugszeichenliste

- A, B: Bereich von Szenarien
- 1: Fahrzeug
- 2: Fahrerassistenzsystem
- 3: Szenario
- 4: Motorrad
- 5a, 5b, 5c, 5d: weitere Fahrzeuge
- 6: Fußgänger
- 11: Mittel zum Simulieren
- 12: Mittel zum Betreiben eines Fahrerassistenzsystems
- 13: Mittel zum Beobachten eines Fahrverhaltens
- 14: Mittel zum Bestimmen einer Fahrsituation
- 15: Mittel zum Ermitteln einer Güte
- 16: Mittel zum Ändern eines Szenarios
- 17: Mittel zum Prüfen einer Abbruchbedingung
- 18: Schnittstelle

## Patentansprüche

1. Computerimplementiertes Verfahren (100) zum Testen eines Fahrerassistenzsystems (2) für ein Fahrzeug (1), folgende Arbeitsschritte aufweisend:
Simulieren (101) eines Szenarios (3), in welchem sich das Fahrzeug (1) befindet;
Betreiben (102) des Fahrerassistenzsystems (2) in einem Umfeld des Fahrzeugs (1) auf der Grundlage des simulierten Szenarios (3);
Beobachten (103) eines Fahrverhaltens des Fahrerassistenzsystems (2) in dem Umfeld des Fahrzeugs (1);
Bestimmen (104) einer Fahrsituation, welche durch das Fahrverhalten des Fahrerassistenzsystems (2) in dem Umfeld des Fahrzeugs (1) entsteht;
Ermitteln (105) einer Güte des simulierten Szenarios (3) in Abhängigkeit eines vordefinierten Kriteriums in Bezug auf die entstandene Fahrsituation, insbesondere einer Gefährlichkeit der entstandenen Fahrsituation;
Prüfen (106) wenigstens einer Abbruchbedingung des Verfahrens (100); und
Ändern (107) des simulierten Szenarios (3) auf der Grundlage der ermittelten Güte, bis die wenigstens eine Abbruchbedingung erfüllt ist,
wobei beim Ändern des simulierten Szenarios (3) ein neues Szenario entsteht, bei dem Parameter ausgetauscht wurden, Parameter weggelassen wurden und/oder neue Parameter hinzugekommen sind.

2. Verfahren (100) nach Anspruch 1, wobei beim Simulieren des Szenarios eine Geschwindigkeit, insbesondere eine initiale Geschwindigkeit, des Fahrzeugs (1) und/oder eine Trajektorie des Fahrzeugs (1) vorgegeben wird.

3. Verfahren (100) nach Anspruch 1 oder 2, wobei beim Ändern des simulierten Szenarios ausschließlich Werte von Parametern des simulierten Szenarios verändert werden.

4. Verfahren (100) nach einem der vorhergehenden Ansprüche 1 bis 3, wobei beim Ändern des simulierten Szenarios (3) ein neues Szenario entsteht, welches aus hintereinander kombinierten Szenarien besteht.

5. Verfahren (100) nach einem der vorhergehenden Ansprüche 1 bis 4, wobei beim Ermitteln der Güte die Güte durch eine fiktive Belohnung charakterisiert ist und das Verändern auf der Grundlage einer Kostenfunktion erfolgt, welche ausgestaltet ist, um die fiktive Belohnung zu maximieren.

6. Verfahren (100) nach einem der vorhergehenden Ansprüche 1 bis 5, wobei das Verändern des simulierten Szenarios (3) unter Verwendung evolutionärer Algorithmen vorgenommen wird.

7. Verfahren (100) nach einem der vorhergehenden Ansprüche 1 bis 6, wobei auf der Grundlage der ermittelten Güte eine Nutzenfunktion approximiert wird, welche beschreibt, welchen Güte-Wert ein bestimmtes simuliertes Szenario (3) hat.

8. Verfahren (100) nach einem der vorhergehenden Ansprüche 1 bis 7, wobei das Fahrerassistenzsystem (2) simuliert wird.

9. Verfahren (100) nach einem der vorhergehenden Ansprüche 1 bis 8, wobei eine Strategie zum Ändern des Szenarios (3) mittels einer Methodik des bestärkenden Lernens auf der Grundlage der ermittelten Güte während des Testbetriebs fortlaufend verbessert wird, bis die Abbruchbedingung erreicht ist.

10. Verfahren (100) nach einem der vorhergehenden Ansprüche 1 bis 9, wobei beim initialen Simulieren des Szenarios historische Daten aus früheren Testbetrieben eines Fahrerassistenzsystems, insbesondere des zu testenden Fahrerassistenzsystems (2), berücksichtigt werden.

11. Verfahren (100) nach einem der vorhergehenden Ansprüche 1 bis 10, wobei beim Betreiben des Fahrerassistenzsystems (2) Daten in Bezug auf das Umfeld (4) des Fahrzeugs (1) in das Fahrerassistenzsystem (2) eingespeist werden und/oder das Fahrerassistenzsystem (2), insbesondere dessen Sensoren, auf der Grundlage des Umfelds (4) des Fahrzeugs (1) stimuliert werden.

12. System (10) zum Testen eines Fahrerassistenzsystems (2) für ein Fahrzeug (1), aufweisend:
Mittel (11) zum Simulieren eines Szenarios (3), in welchem sich das Fahrzeug (1) befindet;
Mittel (12) zum Betreiben des Fahrerassistenzsystems (2) in einem Umfeld des Fahrzeugs (1) auf der Grundlage des simulierten Szenarios (3);
Mittel (13) zum Beobachten eines Fahrverhaltens des Fahrerassistenzsystems (2) in dem Umfeld des Fahrzeugs (1);
Mittel (14) zum Bestimmen einer Fahrsituation, welche durch das Fahrverhalten des Fahrerassistenzsystems (2) in dem Umfeld des Fahrzeugs (1) entsteht;
Mittel (15) zum Ermitteln einer Güte des simulierten Szenarios (3) in Abhängigkeit eines vordefinierten Kriteriums in Bezug auf die Fahrsituation, insbesondere einer Gefährlichkeit der entstandenen Fahrsituation;
Mittel (16) zum Prüfen wenigstens einer Abbruchbedingung des Verfahrens (100); und
Mittel (17) zum Ändern des simulierten Szenarios (3) auf der Grundlage der ermittelten Güte, bis die wenigstens eine Abbruchbedingung erfüllt ist;
wobei beim Ändern des simulierten Szenarios (3) ein neues Szenario entsteht, bei dem Parameter ausgetauscht wurden, Parameter weggelassen wurden und/oder neue Parameter hinzugekommen sind.

13. System (10) zum Testen eines Fahrerassistenzsystems (2) für ein Fahrzeug (1), insbesondere nach Anspruch 12, einen Agenten (16) aufweisend, wobei der Agent (16) eingerichtet ist, um ein Szenario (3) zu erzeugen und um einen Fehler des Fahrerassistenzsystems durch Ändern des Szenarios (3) zu provozieren, und wobei eine Strategie zum Ändern des Szenarios (3), insbesondere mittels einer Methodik des bestärkenden Lernens, durch Interaktion des Agenten (21) mit dem Fahrerassistenzsystem (2) während des Betreibens fortlaufend verbessert wird, bis eine Abbruchbedingung erreicht ist.

14. System (10) nach Anspruch 13, wobei der Agent (16) eingerichtet ist, um eine Fahrsituation, welche durch ein Fahrverhalten des Fahrerassistenzsystems (2) in einem Umfeld (4) des Fahrzeugs (1) auf der Grundlage des simulierten Szenarios (3) entsteht, zu beobachten und eine Güte des Szenarios (3) in Abhängigkeit einer Gefährlichkeit der entstandenen Fahrsituation zu ermitteln.

15. System (10) nach Anspruch 13 oder 14, wobei der Agent (16) auf der Grundlage von historischen Daten vortrainiert ist und diese Daten beim initialen Simulieren des Szenarios (3) durch den Agenten (16) berücksichtigt werden.

## Claims

1. Computer-implemented method (100) for testing a driver assistance system (2) for a vehicle (1), comprising the following steps:
simulating (101) a scenario (3) in which the vehicle (1) is located;
operating (102) the driver assistance system (2) in an environment of the vehicle (1) based on the simulated scenario (3);
observing (103) a driving behavior of the driver assistance system (2) in the environment of the vehicle (1);
determining (104) a driving situation that arises from the driving behavior of the driver assistance system (2) in the environment of the vehicle (1);
determining (105) a quality of the simulated scenario (3) as a function of a predefined criterion with respect to the resulting driving situation, in particular a danger of the resulting driving situation;
checking (106) at least one termination condition of the method (100); and
changing (107) the simulated scenario (3) on the basis of the determined quality until the at least one termination condition is fulfilled,
wherein, when changing the simulated scenario (3), a new scenario is created in which parameters have been exchanged, parameters have been omitted, and/or new parameters have been added.

2. Method (100) according to claim 1, wherein, when simulating the scenario, a speed, in particular an initial speed, of the vehicle (1) and/or a trajectory of the vehicle (1) is specified.

3. Method (100) according to claim 1 or 2, wherein when changing the simulated scenario, only values of parameters of the simulated scenario are changed.

4. Method (100) according to one of the preceding claims 1 to 3, wherein when the simulated scenario (3) is changed, a new scenario is created which consists of scenarios combined in succession.

5. Method (100) according to one of the preceding claims 1 to 4, wherein when determining the quality, the quality is **characterized by** a fictitious reward and the change is made on the basis of a cost function which is designed to maximize the fictitious reward.

6. Method (100) according to one of the preceding claims 1 to 5, wherein the modification of the simulated scenario (3) is performed using evolutionary algorithms.

7. Method (100) according to one of the preceding claims 1 to 6, wherein, on the basis of the determined quality, a utility function is approximated which describes the quality value of a specific simulated scenario (3).

8. Method (100) according to one of the preceding claims 1 to 7, wherein the driver assistance system (2) is simulated.

9. Method (100) according to one of the preceding claims 1 to 8, wherein a strategy for changing the scenario (3) is continuously improved during test operation by means of a reinforcement learning methodology based on the determined quality until the termination condition is reached.

10. Method (100) according to one of the preceding claims 1 to 9, wherein historical data from previous test operations of a driver assistance system, in particular the driver assistance system (2) to be tested, are taken into account during the initial simulation of the scenario.

11. Method (100) according to one of the preceding claims 1 to 10, wherein, when operating the driver assistance system (2), data relating to the environment (4) of the vehicle (1) is fed into the driver assistance system (2) and/or the driver assistance system (2), in particular its sensors, are stimulated on the basis of the environment (4) of the vehicle (1).

12. System (10) for testing a driver assistance system (2) for a vehicle (1), comprising:
means (11) for simulating a scenario (3) in which the vehicle (1) is located;
means (12) for operating the driver assistance system (2) in an environment of the vehicle (1) based on the simulated scenario (3);
means (13) for observing a driving behavior of the driver assistance system (2) in the environment of the vehicle (1);
means (14) for determining a driving situation resulting from the driving behavior of the driver assistance system (2) in the environment of the vehicle (1);
means (15) for determining a quality of the simulated scenario (3) as a function of a predefined criterion relating to the driving situation, in particular a danger of the driving situation that has arisen;
means (16) for checking at least one termination condition of the method (100); and
means (17) for changing the simulated scenario (3) on the basis of the determined quality until the at least one termination condition is fulfilled;
wherein, when the simulated scenario (3) is changed, a new scenario is created in which parameters have been exchanged, parameters have been omitted, and/or new parameters have been added.

13. System (10) for testing a driver assistance system (2) for a vehicle (1), in particular according to claim 12, comprising an agent (16), wherein the agent (16) is configured to generate a scenario (3) and to provoke an error in the driver assistance system by changing the scenario (3), and wherein a strategy for changing the scenario (3), in particular by means of a reinforcement learning methodology, is continuously improved by interaction of the agent (21) with the driver assistance system (2) during operation until a termination condition is reached.

14. System (10) according to claim 13, wherein the agent (16) is configured to observe a driving situation arising from the driving behavior of the driver assistance system (2) in an environment (4) of the vehicle (1) based on the simulated scenario (3) and to determine a quality of the scenario (3) as a function of the danger of the driving situation that has arisen.

15. System (10) according to claim 13 or 14, wherein the agent (16) is pre-trained based on historical data and this data is taken into account by the agent (16) during the initial simulation of the scenario (3).

## Revendications

1. Procédé (100) implémenté par ordinateur pour tester un système d'assistance à la conduite (2) d'un véhicule (1), présentant les étapes de travail suivantes :
la simulation (101) d'un scénario (3) dans lequel se trouve le véhicule (1) ;
le fonctionnement (102) du système d'assistance à la conduite (2) dans l'environnement du véhicule (1) sur la base du scénario simulé (3) ;
l'observation (103) du comportement de conduite du système d'assistance au conducteur (2) dans l'environnement du véhicule (1) ;
la définition (104) d'une situation de conduite résultant du comportement de conduite du système d'assistance à la conduite (2) dans l'environnement du véhicule (1) ;
la détermination (105) de la qualité du scénario simulé (3) en fonction d'un critère prédéfini concernant la situation de conduite résultante, en particulier d'une dangerosité de la situation de conduite résultante ;
la vérification (106) d'au moins une condition d'interruption du procédé (100) ; et
la modification (107) du scénario simulé (3) sur la base de la qualité déterminée jusqu'à ce qu'au moins une condition d'interruption soit remplie,
dans lequel la modification du scénario simulé (3) crée un nouveau scénario dans lequel des paramètres ont été échangés, des paramètres ont été supprimés et/ou de nouveaux paramètres ont été ajoutés.

2. Procédé (100) selon la revendication 1, dans lequel lors de la simulation du scénario, une vitesse, en particulier une vitesse initiale, du véhicule (1) et/ou une trajectoire du véhicule (1) sont prédéfinies.

3. Procédé (100) selon la revendication 1 ou 2, dans lequel, lors de la modification du scénario simulé, seules des valeurs de paramètres du scénario simulé sont modifiées.

4. Procédé (100) selon l'une quelconque des revendications précédentes 1 à 3, dans lequel, lors de la modification du scénario simulé (3), un nouveau scénario est créé, lequel est constitué de scénarios combinés successivement.

5. Procédé (100) selon l'une quelconque des revendications précédentes 1 à 4, dans lequel, lors de la détermination de la qualité, la qualité est **caractérisée par** une récompense fictive et la modification est effectuée sur la base d'une fonction de coût qui est configurée pour maximiser la récompense fictive.

6. Procédé (100) selon l'une quelconque des revendications précédentes 1 à 5, dans lequel la modification du scénario simulé (3) est réalisée à l'aide d'algorithmes évolutifs.

7. Procédé (100) selon l'une quelconque des revendications précédentes 1 à 6, dans lequel, sur la base de la qualité déterminée, une fonction d'utilité est approximée, laquelle décrit la valeur de qualité d'un scénario simulé (3) donné.

8. Procédé (100) selon l'une quelconque des revendications précédentes 1 à 7, dans lequel le système d'assistance à la conduite (2) est simulé.

9. Procédé (100) selon l'une quelconque des revendications précédentes 1 à 8, dans lequel une stratégie de modification du scénario (3) est continuellement améliorée par une méthodologie d'apprentissage de renforcement sur la base de la qualité déterminée pendant le fonctionnement d'essai jusqu'à ce que la condition d'interruption soit atteinte.

10. Procédé (100) selon l'une quelconque des revendications précédentes 1 à 9, dans lequel, lors de la simulation initiale du scénario, des données historiques issues de fonctionnements de test antérieurs d'un système d'assistance à la conduite, en particulier du système d'assistance à la conduite (2) à tester, sont prises en compte.

11. Procédé (100) selon l'une quelconque des revendications précédentes 1 à 10, dans lequel lors du fonctionnement du système d'assistance à la conduite (2), des données relatives à l'environnement (4) du véhicule (1) sont injectées dans le système d'assistance à la conduite (2) et/ou le système d'assistance à la conduite (2), en particulier ses capteurs, sont stimulés sur la base de l'environnement (4) du véhicule (1).

12. Système (10) pour tester un système d'assistance à la conduite (2) d'un véhicule (1), présentant:
des moyens (11) pour simuler un scénario (3) dans lequel se trouve le véhicule (1) ;
des moyens (12) pour faire fonctionner le système d'assistance à la conduite (2) dans un environnement du véhicule (1) sur la base du scénario simulé (3) ;
des moyens (13) pour observer un comportement de conduite du système d'assistance au conducteur (2) dans l'environnement du véhicule (1) ;
des moyens (14) pour définir une situation de conduite résultant du comportement de conduite du système d'assistance à la conduite (2) dans l'environnement du véhicule (1) ;
des moyens (15) pour évaluer une qualité du scénario simulé (3) en fonction d'un critère prédéfini relatif à la situation de conduite, en particulier d'une dangerosité de la situation de conduite résultante ;
des moyens (16) pour vérifier au moins une condition d'interruption du procédé (100) ; et
des moyens (17) pour modifier le scénario simulé (3) sur la base de la qualité déterminée jusqu'à ce qu'au moins une condition d'interruption soit remplie ;
dans lequel lors de la modification du scénario simulé (3) un nouveau scénario est créé, dans lequel des paramètres ont été échangés, des paramètres ont été supprimés et/ou de nouveaux paramètres ont été ajoutés.

13. Système (10) pour tester un système d'assistance à la conduite (2) pour un véhicule (1), en particulier selon la revendication 12, présentant un agent (16), dans lequel l'agent (16) est mis au point pour générer un scénario (3) et provoquer une erreur du système d'assistance à la conduite en modifiant le scénario (3), et dans lequel une stratégie de modification du scénario (3) est continuellement améliorée par l'interaction de l'agent (21) avec le système d'assistance à la conduite (2) pendant le fonctionnement, en particulier au moyen d'une méthodologie d'apprentissage de renforcement, jusqu'à ce qu'une condition d'interruption soit atteinte.

14. Système (10) selon la revendication 13, dans lequel l'agent (16) est mis au point pour observer une situation de conduite résultant du comportement de conduite du système d'assistance à la conduite (2) dans un environnement (4) du véhicule (1) sur la base du scénario simulé (3) et pour déterminer une qualité du scénario (3) en fonction d'une dangerosité de la situation de conduite résultante.

15. Système (10) selon la revendication 13 ou 14, dans lequel l'agent (16) est préentraîné sur la base de données historiques et ces données sont prises en compte lors de la simulation initiale du scénario (3) par l'agent (16).
